**Europäisches Patentamt**

**European Patent Office**

**Office européen des brevets**

(19)

(11) Veröffentlichungsnummer: **0 200 175**
**A2**

(12) # EUROPÄISCHE PATENTANMELDUNG

(21) Anmeldenummer: 86105762.8

(22) Anmeldetag: 25.04.86

(51) Int. Cl.⁴: **H 01 H 1/40**
**H 01 H 11/06**

(30) Priorität: 03.05.85 DE 3515911

(43) Veröffentlichungstag der Anmeldung:
05.11.86 Patentblatt 86/45

(84) Benannte Vertragsstaaten:
FR GB IT

(71) Anmelder: SWF Auto-Electric GmbH
Stuttgarter Str. 119
D-7120 Bietigheim-Bissingen(DE)

(72) Erfinder: Erdelitsch, Herbert
Berliner Strasse 8
D-712 Bietigheim-Bissingen(DE)

(72) Erfinder: Hecht, Walter
Sudetenstrasse 86
D-712 Bietigheim-Bissingen(DE)

(72) Erfinder: Rachner, Horst
Weingartweg 8
D-712 Bietigheim-Bissingen(DE)

(54) Elektrischer Schalter, insbesondere Lenkstockschalter für Kraftfahrzeuge.

(57) Bei einem elektrischen Schalter sind in eine Grundplatte aus Kunststoff aus einer Blechplatine ausgestanzte Leiterbahnen mit Festkontakten und Steckkontakten eingegossen. Die Festkontakte sind auf ihrer Oberseite vom Kunststoff frei gespart. Damit eine genaue Lage der Leiterbahnen, vor allem der Festkontakte, im Kunststoff gewährleistet ist, befindet sich auch auf der Unterseite eines Festkontaktes eine bis zur Unterseite des Festkontaktes reichende Freisparung im Kunststoff, so daß der Festkontakt während des Eingießens in die Grundplatte auf beiden Seiten am Werkzeug abgestützt werden kann.

Fig. 1

A 12 866

Elektrischer Schalter, insbesondere Lenkstockschalter für Kraftfahrzeuge
_____

Die Erfindung geht aus von einem elektrischer Schalter, der insbesondere als Lenkstockschalter für Kraftfahrzeuge verwendet werden soll und der die Merkmale aus dem Oberbegriff des Anspruchs 1 aufweist.

Ein elektrischer Schalter mit diesen Merkmalen ist aus der DE-OS 32 17 929 bekannt. Dieser Schalter hat eine Grundplatte aus Kunststoff, in die aus einer Blechplatine ausgestanzte Leiterbahnen eingegossen sind. Sowohl die Festkontakte als auch die Steckkontakte des elektrischen Schalters werden von Abschnitten der Leiterbahnen gebildet. Festkontakte sind auf ihrer Oberseite, auf der sie von einem Schaltkontakt befahren werden, von Kunststoff freigespart und liegen mit ihrer Oberseite in einer Ebene mit zwischen ihnen befindlichen Bereichen der Grundplatte.

Bei dem bekannten Schalter ist nicht mit genügender Sicherheit gewährleistet, daß die Leiterbahnen und vor allem die von Abschnitten der Leiterbahnen gebildeten Festkontakte jeweils die gewünschte exakte Lage in der Grundplatte einnehmen.

Aufgabe der Erfindung ist es, einen elektrischer Schalter mit den Merkmalen aus dem Oberbegriff des Anspruchs 1 so weiterzubilden, daß die Exemplarstreuung im Hinblick auf die Lage der Leiterbahnen verringert werden kann.

Diese Aufgabe ist erfindungsgemäß dadurch lösbar, daß man einen elektrischen Schalter, der die Merkmale aus dem Oberbegriff des Anspruchs 1 aufweist, zusätzlich mit dem Merkmal aus dem kennzeichnenden Teil des Anspruchs 1 ausstattet. Bei einem erfindungsgemäßen elektrischen Schalter ist also nicht nur die gesamte Oberseite eines Festkontakts von Kunststoff freigespart. Es befindet sich vielmehr auch auf der Unterseite eines Festkontaktes eine bis zur Unterseite des Festkontakts reichende Freisparung im Kunststoff. Es ist nun möglich, den Festkontakt während des Eingießens in die Grundplatte auf beiden Seiten am Werkzeug abzustützen, so daß seine Lage sehr genau fixiert ist und seine Oberseite mit Sicherheit frei von Kunststoff bleibt.

Vorteilhafterweise ist die Freisparung auf der Unterseite eines Festkontakts kleiner als die Fläche des Festkontakts, so daß der Festkontakt auf der Unterseite noch von Kunststoff unterstützt ist. Gemäß Anspruch 3 befindet sich die Freisparung auf der Unterseite nahe an einer Kante des Festkontakts. Somit wird der Festkontakt besonders an dieser Kante gegen den die Freisparung auf seiner Oberseite bewirkenden Werkzeugabschnitt gedrückt, so daß kein Kunststoff zwischen die Oberseite des Festkontakts und dem erwähnten Werkzeugabschnitt eindringen kann. Günstiger als eine große können mehrere kleine Freisparungen auf der Unterseite eines Festkontakts sein.

Die Blechplatine kann noch genauer fixiert werden, wenn sich gemäß Anspruch 5 auch außerhalb der Festkontakte zu beiden Seiten der Blechplatine Freisparungen in der Grundplatte befinden. Am besten liegen sich diese Freisparungen gemäß Anspruch 6 gegenüber.

Gemäß Anspruch 7 sind zur leichten Handhabung die Leiterbahnen der ausgestanzten und eingegossenen Blechplatine noch durch Stege miteinander verbunden. Vorteilhafterweise befindet sich dann über und unter einem Steg jeweils eine Freisparung im Kunststoff der Grundplatte. Mit Hilfe dieser Freisparungen kann die Blechplatine gut fixiert werden. Zugleich erleichtern diese Freisparungen das Durchtrennen der Stege nach oder vor dem Spritzgießen. Es ist günstig, wenn sich gemäß Anspruch 8 nur außerhalb der Freisparung auf der Oberseite von benachbarten Festkontakten Stege zwischen den Leiterbahnen befinden. Würden sich auch zwischen den Festkontakten Stege befinden, so bestünde die Gefahr, daß beim Durchtrennen der Stege die Lage der Festkontakte verändert wird. Dies ist durch die Ausbildung gemäß Anspruch 8 ausgeschlossen.

Sehr einfach ist es, wenn die Freisparungen, insbesondere die Freisparungen auf der Unterseite der Festkontakte einen kreisförmigen Rand haben. Denn zylindrische Stifte am Werkzeug sind besonders leicht herzustellen. Die Freisparung auf der Oberseite der Festkontakte ist natürlich entsprechend der Form dieser Festkontakte und dem Weg des oder der die Festkontakte befahrenden Schleifkontakte auszubilden.

Gemäß Anspruch 10 reicht eine Freisparung jeweils nur bis zur Ober- bzw. Unterseite der Blechplatine. Dies trägt zum festen Halt bei und vereinfacht das Werkzeug.

Die Ausbildung nach Anspruch 11 ist besonders dann vorteilhaft, wenn sich die Freisparungen an den Stegen befinden und diese Stege im Formwerkzeug noch vor dem Eingießen des Kunststoffs durchtrennt werden. Denn durch die übergreifenden Freisparungen können dann noch die Leiterbahnen gehalten werden.

Ein Ausführungsbeispiel eines erfindungsgemäßen elektrischen Lenkstockschalters ist in den Zeichnungen dargestellt. Anhand der Fig. dieser Zeichnungen soll die Erfindung nun näher erläutert werden.

Es zeigen:

Fig. 1  einen axialen Schnitt durch das Ausführungsbeispiel mit zwei Schalthebeln und zwei Grundplatten,

Fig. 2  eine Draufsicht auf die Oberseite der einen Grundplatte,

Fig. 3  einen Schnitt entlang der Linie III-III aus Fig. 2,

Fig. 4  eine Draufsicht auf die Unterseite der Grundplatte,

Fig. 5  einen Schnitt entlang der Linie V-V aus Fig. 4, wobei die Grundplatte noch nicht endgültig fertig ist, und

Fig. 6  ein Schnitt entlang der Linie VI-VI aus Fig. 2.

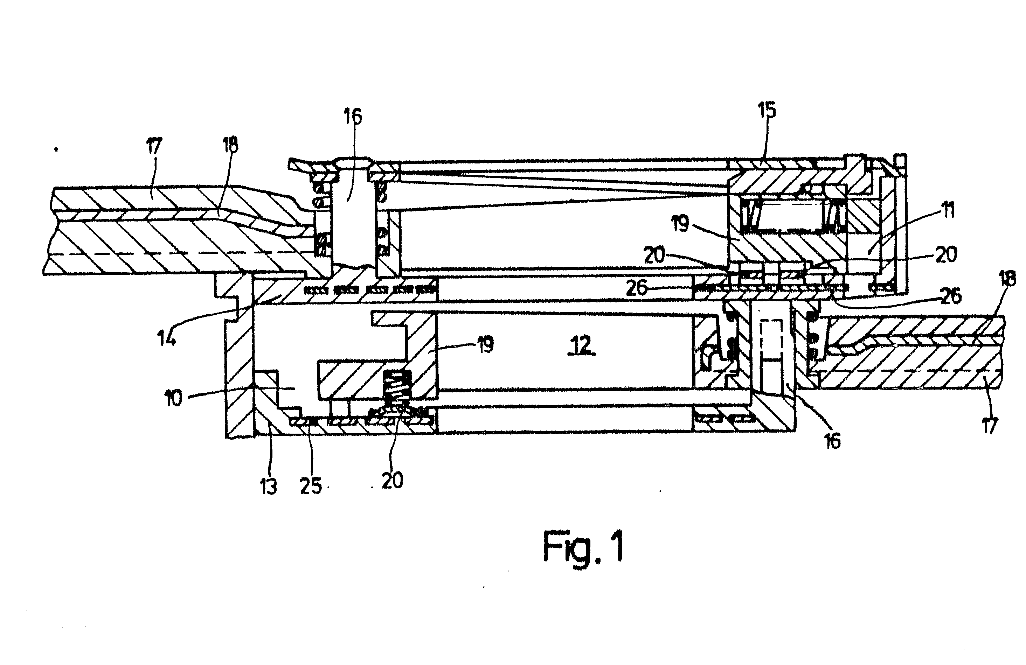

Der in Fig. 1 vollständig gezeigte Lenkstockschalter weist zwei Gehäusekammern 10 und 11 auf, die in Achsrichtung eines zentralen Durchbruchs 12 durch den Lenkstockschalter übereinanderliegen. Die eine Kammer befindet sich zwischen einer ersten Grundplatte 13 und einer im Abstand zu dieser verlaufenden zweiten Grundplatte 14. Die zweite Kammer 11 wird im wesentlichen durch die zweite Grundplatte 14 und einer im Abstand zu dieser liegenden metallischen Abdeckscheibe 15 gebildet.

Die Grundplatten 13 und 14 sind im Spritzgießverfahren aus Kunststoff geformt und tragen an bezüglich der Achse des Durchbruchs 12 sich diametral gegenüberliegenden Stellen einstückig jeweils einen Zapfen 16, dessen Achse sich in Richtung der Achse des Durchbruchs 12 erstreckt und auf dem jeweils ein Schalthebel 17 drehbar gelagert ist. Auch die Schalthebel 17 sind aus Kunststoff gefertigt, zur Stabilitätserhöhung jedoch durch eine Metalleinlage 18 verstärkt. Einstückig an jeden Schalthebel 17 ist ein ringförmiges Schaltglied 19 angeformt, mit dem ein oder mehrere Schaltkontakte 20, die als Schleifkontakte funktionieren, in einer zur Achse des Durchbruchs 12 senkrechten Ebene bewegt werden können.

Die in der Kammer 10 befindlichen Schaltkontakte 20 wirken mit Festkontakten 25 und die in der Gehäusekammer 11 befindlichen Schaltkontakte 20 mit Festkontakten 26 zusammen.

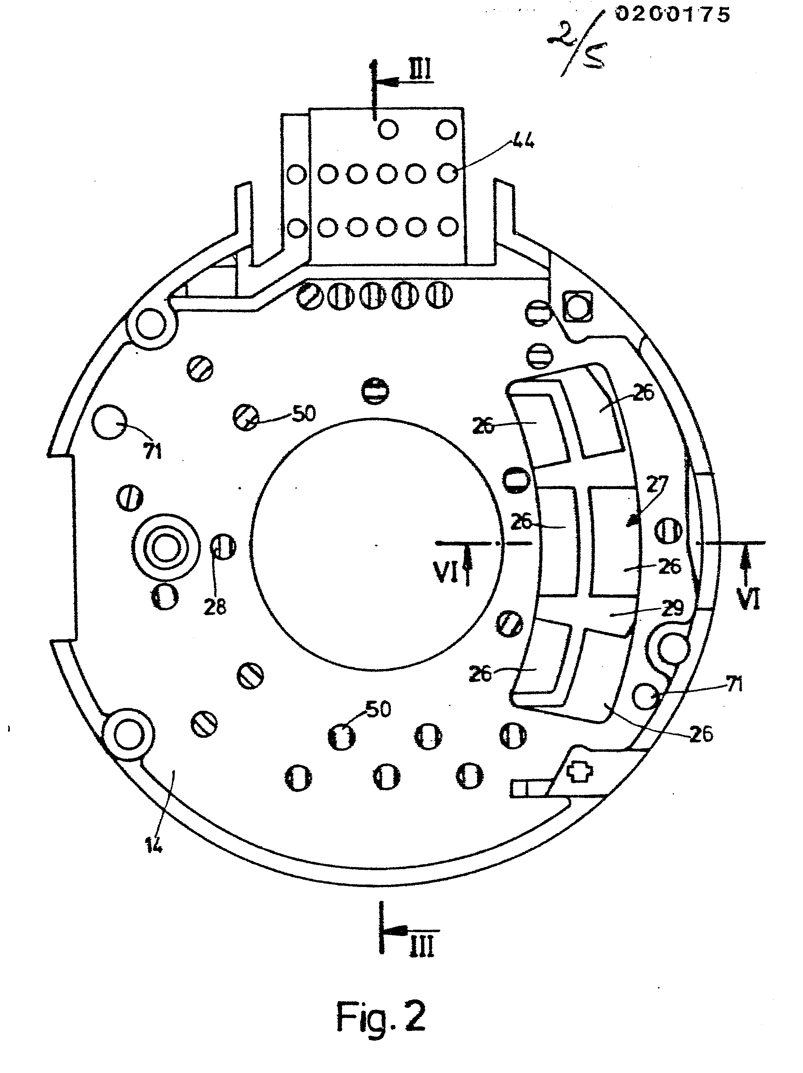

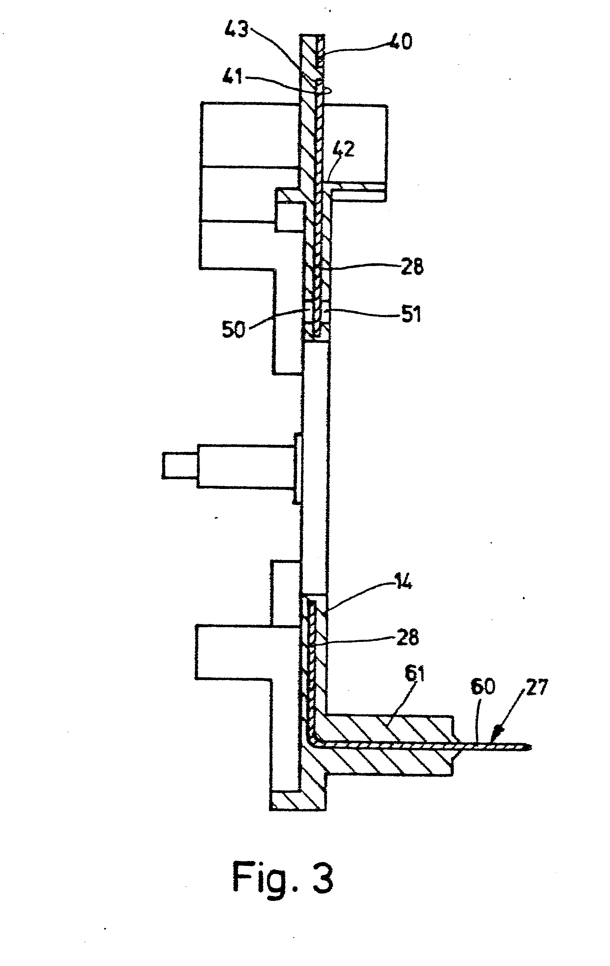

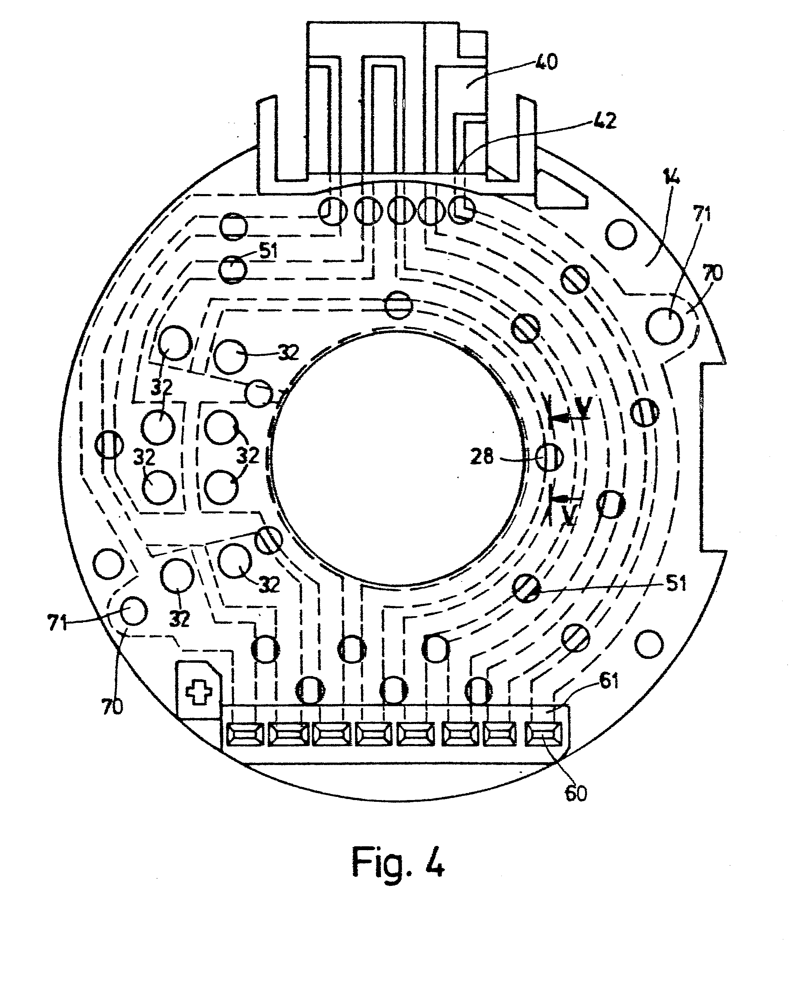

Da der prinzipielle Aufbau der beiden Grundplatten 13 und 14 gleich ist, wird im folgenden anhand der Fig. 2 bis 6 nur noch die Grundplatte 14 näher betrachtet.

Die Festkontakte 26 werden von Abschnitten von aus einer Blechplatine 27 ausgestanzten Leiterbahnen 28 gebildet, die vor dem Spritzen der Grundplatte in das Werkzeug eingelegt und dann vom Kunststoff umgossen werden.

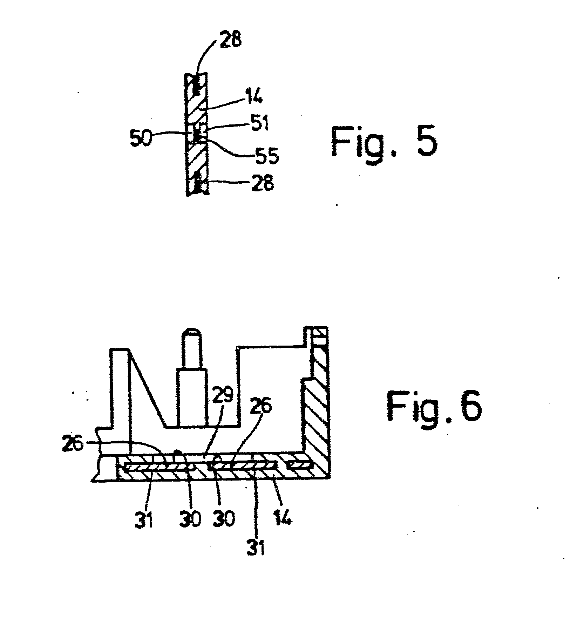

Wie insbesondere die Fig. 2 und 6 zeigen, sind die Festkontakte 26 benachbart zueinander in einer Gruppe angeordnet. Durch eine große Freisparung 29 im Kunststoff der Grundplatte 14 liegen ihre Oberseiten 30 frei, so daß die zwei Schaltkontakte 20 über sie hinwegschleifen können. Die Tiefe der Aussparung 29 entspricht auch zwischen den Festkontakten 26 dem Abstand, den die Oberseiten 30 der Festkontakte 26 von der in Fig. 2 sichtbaren Oberseite der Grundplatte 14 haben. Zwischen den Festkontakten 26 befindet sich also Kunststoffmaterial der Grundplatte 14, so daß innerhalb der Freisparung 29 eine völlig ebene auf dem Niveau der Oberseiten 30 der Festkontakte 26 liegende Ebene gebildet wird. Dies wirkt sich positiv auf das Schaltverhalten des Lenkstockschalters aus. Denn die Schaltkontakte 20 können dann, ohne daß sie irgendwo haken, bewegt werden. Dies führt zu weniger Prellungen, zu einem geringeren Abbrand und zu einer Erniedrigung der Schaltgeräusche.

Durch die Freisparung 29 können die Festkontakte 26 auf der einen Seite am Werkzeug abgestützt werden. Dadurch ist jedoch noch nicht gewährleistet, daß sie sehr genau in einer Ebene liegen und ihre Oberseiten völlig frei von Kunststoff bleiben. Deshalb befindet sich auch auf der Unterseite 31 jedes
der Festkontakte 26 eine bis zur Unterseite 31 des Festkontakts 26 reichende
Freisparung 32 im Kunststoff der Grundplatte 14. Diese Freisparungen 32 sind
kleiner als die Fläche des jeweiligen Festkontaktes, so daß die Festkontakte
26 auf der Unterseite 31 noch von Kunststoff unterstützt sind. Die
Außenkontur der Freisparungen 32 ist kreisförmig. Aufgrund der Aussparungen
32 können die Festkontakte 26 im Werkzeug auch von ihrer Unterseite her am
Werkzeug abgestützt sein. Es ist nun kein Problem mehr, den Abstand zwischen
den Werkzeugteilen, die die Freisparung 29 bzw. die Freisparungen 32
bewirken, so groß wie die Stärke der Blechplatine 27 zu machen und damit die
Festkontakte 26 in ihrer Lage eindeutig zu fixieren. Damit die Festkontakte
26 vor allem an ihren Kanten, und da vor allem an den Kanten, über die ein
Schleifkontakt beim Umschalten von Kunststoff auf den Festkontakt oder
umgekehrt wechselt, genau fixiert sind, reichen die Freisparungen 32 bis
nahe an diese Kanten heran. Da die Festkontakte zu je drei in zwei Reihen
angeordnet sind und der mittlere Festkontakte 26 jeder Reihe zwei Kanten,
über die ein Schleifkontakt 20 wechselt, besitzt, befinden sich auf der
Unterseite des mittleren Festkontaktes 26 zwei Freisparungen 32. Zwei
kreisförmige Freisparungen 32 sind nämlich leichter zu machen als eine große
längliche Freisparung.

Die Grundplatte 14 trägt eine zweite Gruppe von Festkontakten 40, deren
Oberseite 41 entgegengesetzt zu den Oberseiten 30 der Festkontakte 26
gerichtet ist. Durch eine Freisparung 42 liegen die Oberseiten der
Festkontakte 40 frei. Genauso wie bei den Festkontakten 26 befinden sich
auch bei den Festkontakten 40 an deren Unterseite 43 Freisparungen 44, die
wiederum eine kreisförmige Außenkontur haben, jedoch kleiner sind als die
Freisparungen 32, so daß auch sie seitlich nicht über die Kanten der
gegenüber den Festkontakten 26 schmaleren Festkontakte 40 hinausragen.

Auch außerhalb der beiden Gruppen von Festkontakten 26 bzw. 40 befinden sich
zu beiden Seiten der Blechplatine 27 kreisförmige Freisparungen 50 bzw. 51
in der Grundplatte 14. Die Freisparungen 50 und 51 sind alle gleich groß und
reichen jeweils von der Ober- bzw. der Unterseite der Grundplatte 14 bis zur
Blechplatine 27. Einer Freisparung 50 liegt jeweils eine Freisparung 51
gegenüber, so daß die Blechplatine 27 an vielen gegenüberliegenden Stellen
im Werkzeug unterstützt werden kann.

Zur besseren Handhabung werden die Leiterbahnen 28 aus der Blechplatine 27
so ausgestanzt, daß sie untereinander noch durch schmale Stege verbunden
sind. In diesem zusammenhängenden Zustand werden sie in das Spritzwerkzeug
gelegt, mit Kunststoff umgossen und wieder aus dem Spritzwerkzeug genommen.
Erst jetzt werden die Stege zur Isolation der einzelnen Leiterbahnen 28
voneinander durchtrennt. Die Aussparungen 50 und 51 befinden sich nun, wie
besonders deutlich aus Fig. 5 ersichtlich ist, die einen Ausschnitt der
Grundplatte vor dem Durchtrennen der Stege 55 zeigt, über und unter den
Stegen 55, so daß diese leicht durchtrennt werden können. Die Stege 55 sind
jedoch nur außerhalb der beiden Gruppen von Festkontakten 26 bzw. 40
vorgesehen, damit die Festkontakte beim Durchtrennen der Stege nicht
verbogen oder aus dem Kunststoff der Grundplatte gerissen werden.

Es ist auch möglich, die Stege 55 nach dem Einlegen in das Werkzeug und
schon vor dem Eingießen des Kunststoffs zu durchtrennen. Da die
Freisparungen 50 und 51 breiter sind als der Abstand zweier Leiterbahnen 28
voneinander, können dann durch die Freisparungen hindurch die Leiterbahnen
noch gehalten werden.

Auch die Steckkontakte 60, über die die Festkontakte 26 und 40 mit dem
elektrischen Bordnetz eines Kraftfahrzeugs verbunden werden können, werden
durch Abschnitte der Leiterbahnen 28 gebildet. Sie sind rechtwinklig aus der
Ebene der Grundplatte 14 abgebogen und stehen frei über einen länglichen
Halteansatz 61 vor.

Bezüglich der Achse der Grundplatte 14 diametral gegenüberliegend sind an
die Blechplatine 27 zwei innerhalb der Grundplatte 14 liegende Augen 70 mit
jeweils einem Durchbruch 71 angeformt. Mit Hilfe der Durchbrüche 71 wird die
Blechplatine im Werkzeug bezüglich ihrer Achse fixiert.

SWF   Auto - Electric   GmbH

7120 Bietigheim-Bissingen

PAL/A 12 866

Nickel/Tü

26.4.1985

Elektrischer Schalter, insbesondere Lenkstockschalter für Kraftfahrzeuge

Patentansprüche:

1. Elektrischer Schalter, insbesondere Lenkstockschalter für Kraftfahrzeuge, mit einer Grundplatte (13,14) aus Kunststoff, mit Festkontakten (25,26,40) und Steckkontakten (60), die von der Grundplatte (13,14) getragen und von Abschnitten von aus einer Blechplatine (27) ausgestanzten und in die Grundplatte (14) eingegossenen Leiterbahnen (28) gebildet werden, wobei die Festkontakte (25,26,40) auf ihrer von einem oder mehreren Schaltkontakten (20) beaufschlagten Oberseite (30,41) von Kunststoff freigespart sind, und mit ihrer Oberseite (30,41) vorzugsweise in einer Ebene mit zwischen ihnen befindlichen Bereichen der Grundplatte (14) liegen, dadurch gekennzeichnet, daß sich auch auf der Unterseite (31,43) eines Festkontakts (25,26,40) eine bis zur Unterseite (31,43) des Festkontakts (25,26,40) reichende Freisparung (32,44) im Kunststoff befindet, durch die der Festkontakt (25,26,40) während des Eingießens in die Grundplatte (13,14) am Werkzeug abgestützt war.

2. Elektrischer Schalter nach Anspruch 1, dadurch gekennzeichnet, daß die Freisparung (32,44) auf der Unterseite (31,43) eines Festkontakts (25,26,40) kleiner ist als die Fläche des Festkontakts (25,26,40), so daß der Festkontakt (25,26,40) auf der Unterseite (31,43) noch von Kunststoff unterstützt ist.

3. Elektrischer Schalter nach Anspruch 2, dadurch gekennzeichnet, daß sich die Freisparung (32,44) auf der Unterseite (31,43) nahe an einer Kante des Festkontakts (25,26,40) befindet bzw. bis nahe an eine Kante des Festkontakts (25,26,40) heranreicht.

4. Elektrischer Schalter nach Anspruch 2 oder 3, dadurch gekennzeichnet, daß sich auf der Unterseite (31,43) eines Festkontakts (26,40) wenigstens zwei Freisparungen (32,44) befinden.

5. Elektrischer Schalter nach einem der Ansprüche 1 bis 4, dadurch gekennzeichnet, daß sich auch außerhalb der Festkontakte (25,26,40) zu beiden Seiten der Blechplatine (27) Freisparungen (50,51) in der Grundplatte (14) befinden.

6. Elektrischer Schalter nach Anspruch 5, dadurch gekennzeichnet, daß eine Freisparung (50) auf der einen Seite der Blechplatine (27) innerhalb der Kontur einer Freisparung (51) auf der anderen Seite liegt.

7. Elektrischer Schalter nach Anspruch 6, dadurch gekennzeichnet, daß die Leiterbahnen (28) der ausgestanzten oder eingegossenen Blechplatine (27) noch durch Stege (55) miteinander verbunden sind und daß sich über und unter einem Steg (55) jeweils eine Freisparung (50,51) im Kunststoff der Grundplatte (14) befindet.

8. Elektrischer Schalter nach Anspruch 7, dadurch gekennzeichnet, daß sich nur außerhalb der Freisparung (29,42) auf der Oberseite (30,41) von benachbarten Festkontakten (26,40) Stege (55) zwischen den Leiterbahnen (28) befinden.

9. Elektrischer Schalter nach einem der vorhergehenden Ansprüche, dadurch gekennzeichnet, daß Freisparungen (32,44,50,51), insbesondere die Freisparungen auf der Unterseite (31,43) der Festkontakte (26,40), einen kreisförmigen Rand haben.

10. Elektrischer Schalter nach einem der vorhergehenden Ansprüche, dadurch gekennzeichnet, daß eine Freisparung (29,32,42,44,50,51) jeweils nur bis zur Ober- bzw. Unterseite der Blechplatine (27) reicht.

11. Elektrischer Schalter nach einem der vorhergehenden Ansprüche, dadurch gekennzeichnet, daß Freisparungen (50,51) zwischen zwei Leiterbahnen (28) beide Leiterbahnen (28) teilweise übergreifen.

Fig. 1

Fig. 2

Fig. 3

Fig. 4

Fig. 5

Fig. 6